# FASCICULE DE BREVET EUROPEEN

(11) **EP 2 923 385 B1**
(45) Date de publication et mention de la délivrance du brevet: **24.08.2016**
(21) Numéro de dépôt: 13792707.5
(22) Date de dépôt: 21.11.2013
(51) Int. Cl.: H01L 31/18, H01L 31/048, G01R 31/40

(54) **MÉTHODE ET INSTALLATION DE CONTRÔLE DE LA PRESSION INTERNE D'UN MODULE PHOTOVOLTAÏQUE**
VERFAHREN UND ANLAGE ZUR STEUERUNG DES INNENDRUCKS EINES PHOTOVOLTAIKMODULS
METHOD AND FACILITY FOR CONTROLLING THE INTERNAL PRESSURE OF A PHOTOVOLTAIC MODULE

(30) Priorité: 23.11.2012 FR 1261186
(43) Date de publication de la demande: 30.09.2015
(73) Titulaire: "Apollon Solar", 69002 Lyon (FR); COMMISSARIAT A L'ENERGIE ATOMIQUE ET AUX ENERGIES ALTERNATIVES, 75015 Paris (FR)
(72) Inventeur: NICHIPORUK, Oleksiy, F-69780 Mions (FR); LEFILLASTRE, Paul, F-75013 Paris (FR); DUPUIS, Julien, F-77590 Bois le Roi (FR)
(74) Mandataire: Lavoix
(86) Numéro de dépôt international: PCT/EP2013/074406
(87) Numéro de publication internationale: WO 2014/079945

(56) Documents cités:
- WO-A1-2012/072792
- DE-A1-102008 009 503

## Description

L'invention a trait à une méthode de contrôle de la pression interne d'un module photovoltaïque du type comprenant un volume intérieur en dépression par rapport à l'atmosphère ambiante et dans lequel un contact électrique entre des cellules photovoltaïques et des conducteurs d'interconnexion électrique est réalisé uniquement par pression, comme envisagé dans WO-A-03/038 911, WO-A-2004/095 586 ou WO-A-2012/072 792.

Lors de la fabrication de modules photovoltaïques de ce type, il importe que les liaisons électriques entre les cellules et les conducteurs d'interconnexion électrique soient réalisées de façon fiable et pérenne. C'est pourquoi, il est connu de WO-A-03/038 911 et WO-A-2004/095 586 d'utiliser un joint périphérique qui assure l'étanchéité entre le volume interne d'un module et l'atmosphère extérieure. En pratique, la différence de pression entre le volume intérieur du module et l'atmosphère ambiante crée une force permettant le contact par pression entre les conducteurs d'interconnexion et les cellules photovoltaïques.

La valeur de la dépression régnant à l'intérieur du module photovoltaïque est donc un paramètre important pour un tel module. Au sens de la présente invention, la notion de dépression est une notion relative et correspond à une pression absolue inférieure à celle de l'environnement du module.

Pour fixer la dépression qui doit régner à l'intérieur d'un module photovoltaïque du type précité, il faut tenir compte de la plage de température de fonctionnement d'un tel module, typiquement entre -40° C et +90° C. Une dépression insuffisante dans le module, par rapport à la pression ambiante, limite, voire supprime, l'effort du contact par pression entre les conducteurs d'interconnexion et les cellules, ce qui peut entraîner une perte de contact électrique lorsque la température du module est élevée, à cause de la dilatation du gaz présent dans le module qui entraîne une augmentation de sa pression interne. A l'inverse, une dépression trop intense induit un effort de contact par pression trop important et un risque de casse des cellules photovoltaïques lorsque la température du module est faible.

De plus, la pression interne du module doit être ajustée en fonction de son lieu d'exploitation, notamment si le module doit être installé en altitude où la pression extérieure est relativement faible, ceci afin de conserver une même gamme de différences de pression entre l'intérieur et l'extérieur du module, pour éviter les problèmes mentionnés ci-dessus.

La création d'une dépression dans le module a lieu lors de la fabrication de celui-ci, en ligne. Il est connu de réaliser une telle dépression, lorsque tous les composants internes du module ont été mis en place entre sa plaque avant et sa plaque arrière, en plaçant l'ensemble dans une presse, elle-même incluse dans une cloche à vide. La cloche à vide est mise en dépression, à une pression correspondant à une valeur de consigne. Lorsque la pression à l'intérieur de la cloche atteint la valeur de consigne, le module est pressé, afin qu'un joint périphérique puisse garantir l'étanchéité du module à l'air et à l'eau. La cloche est ensuite remise à pression atmosphérique et le module est libéré.

Durant cette étape de pressage, il est essentiel de garantir que la valeur de la dépression réellement créée dans le module est conforme à la valeur de consigne. Cette valeur réelle de dépression dépend principalement de la pression de consigne, de la température à l'intérieur de la cloche à vide et de l'intensité de l'effort de pressage du module. Même si ces paramètres sont a priori relativement faciles à contrôler, il s'avère que les capteurs utilisés ne sont jamais totalement fiables et que des inhomogénéités de température dans la cloche à vide, dans la presse ou dans l'environnement de la ligne de production de module, peuvent ajouter des incertitudes sur la dépression réelle à l'intérieur du module. Il est donc important de disposer d'un moyen de contrôle direct de la pression interne du module au cours de sa production, pour effectuer une opération de contrôle.

Dans ce but, il est connu de mesurer la pression interne d'un module photovoltaïque au moyen d'un capteur de pression inséré à l'intérieur du module et communiquant avec l'extérieur par voie RFID. Cette solution nécessite d'introduire un élément supplémentaire dans le module, ce qui pose un problème de dégazage potentiel du capteur, au cours du temps. Ce dégazage peut induire une augmentation de pression et remettre en cause la fiabilité du module. En outre, l'esthétique du module est modifiée du fait de l'incorporation du capteur, ce qui pose un problème en termes de commercialisation. De plus, comme l'épaisseur interne du module, c'est-à-dire la distance entre les faces en regard de sa plaque avant et de sa plaque arrière, est faible, généralement de l'ordre de 1 mm, il est nécessaire d'utiliser un capteur mince, donc spécifique et d'un prix de revient relativement élevé. En variante, il est possible d'utiliser un capteur plus épais, en prévoyant des logements en creux dans les faces en regard des plaques avant et arrière du module. Si cette solution permet d'utiliser un capteur plus classique, donc économique, elle impose de modifier les plaques, qui sont par exemple en verre. Ceci n'est pas aisé et nécessite d'utiliser des types de verres spécifiques, d'où l'impossibilité de tester d'autres verres. En outre, la réalisation de ces logements en creux fragilise localement la plaque avant ou la plaque arrière.

C'est à ces inconvénients qu'entend plus particulièrement remédier l'invention en proposant une nouvelle méthode de contrôle de la pression interne d'un module photovoltaïque qui ne nécessite pas l'utilisation d'un capteur et qui permet de connaître, avec un degré de précision acceptable, la pression interne d'un module, d'où une bonne prévisibilité de l'effort de contact entre les conducteurs d'interconnexion électrique et les cellules auxquelles ils sont associés.

A cet effet, l'invention concerne une méthode de contrôle de la pression interne d'un module photovoltaïque comprenant une plaque avant, une plaque arrière, des cellules photovoltaïques, des conducteurs d'interconnexion électrique entre les cellules et un joint périphérique, alors que les connecteurs sont en contact par pression avec les cellules, sous l'effet d'un effort résultant d'une dépression régnant à l'intérieur du module. Conformément à l'invention, cette méthode comprend des étapes consistant à :
a) faire diminuer progressivement la pression d'une quantité de gaz autour du module,
b) détecter, au cours de l'étape a), un paramètre physique représentatif de l'appui effectif des conducteurs contre les cellules,
c) déterminer une valeur de la pression interne du module en fonction d'une variation du paramètre physique.

Grâce à l'invention, la détection de la pression interne du module est effectuée de façon indirecte, sans avoir recours à un capteur intégré au module, en considérant que la pression interne du module est égale à la pression de la quantité de gaz présente autour du module, lorsqu'une variation du paramètre physique est détectée.

Selon des aspects avantageux mais non obligatoires de l'invention, une telle méthode peut incorporer une ou plusieurs des caractéristiques suivantes, prises dans toute combinaison techniquement admissible :
- L'étape a) est effectuée en disposant le module dans une enceinte à pression contrôlée et en faisant progressivement décroître la pression à l'intérieur de cette enceinte, à partir de la pression atmosphérique.
- La valeur de la pression déterminée lors de l'étape c) correspond à la pression pour laquelle le paramètre physique varie du fait d'un relâchement de l'effort de contact par pression, entre au moins un conducteur d'interconnexion et une cellule photovoltaïque.
- Le paramètre détecté lors de l'étape b) est une impédance du module alors que, lors de l'étape b), on injecte un courant électrique dans le module et on détecte une variation d'une composante de ce courant.
- Le courant injecté à l'étape b) est à tension constante et la composante détectée est l'intensité du courant.
- Le courant injecté à l'étape b) est à intensité constante et la composante détectée est la tension aux bornes du module.
- Le paramètre détecté lors de l'étape b) est un paramètre géométrique de la plaque avant et/ou de la plaque arrière du module.
- Le paramètre détecté lors de l'étape b) est représentatif de la planéité de la plaque avant ou de la plaque arrière.
- Lors de l'étape b), le paramètre est détecté par voie optique, notamment par déplacement d'au moins un faisceau lumineux réfléchi ou dévié par la plaque avant ou la plaque arrière.
- Lors de l'étape c), la pression interne du module est considérée comme égale à la pression de la quantité de gaz autour du module lorsque la valeur du paramètre physique détecté varie d'un pourcentage prédéterminé par rapport à sa valeur d'origine, ce pourcentage étant compris entre 1 et 5%, de préférence égal à 2%.

Par ailleurs, l'invention concerne une installation permettant de mettre en oeuvre une méthode telle que mentionnée ci-dessus et, plus spécifiquement, une installation de contrôle de la pression interne d'un module photovoltaïque, ce module comprenant une plaque avant, une plaque arrière, des cellules photovoltaïques, des conducteurs d'interconnexion électrique entre les cellules, ainsi qu'un joint périphérique, les conducteurs étant en contact par pression avec les cellules, sous l'effet d'un effort résultant d'une dépression régnant à l'intérieur du module. Conformément à l'invention, cette installation comprend :
- une enceinte de réception du module au sein d'une quantité de gaz, cette enceinte étant équipée de moyens pour faire diminuer la pression de cette quantité de gaz,
- des moyens de détection, pendant la diminution de la pression de la quantité de gaz, d'un paramètre physique représentatif de l'appui effectif des conducteurs d'interconnexion sur les cellules et
- des moyens de détermination de la pression interne du module, sur la base d'un signal de sortie des moyens de détection.

L'invention sera mieux comprise et d'autres avantages de celle-ci apparaîtront plus clairement à la lumière de la description qui va suivre de plusieurs modes de réalisation d'une méthode et d'une installation conformes à son principe, donnée uniquement à titre d'exemple et faite en référence aux dessins annexés dans lesquels :
- la figure 1 est une représentation schématique de principe d'une installation conforme à un premier mode de réalisation de l'invention ;
- la figure 2 est une représentation schématique de principe de l'évolution du courant détecté par l'ampèremètre de l'installation de la figure 1, en fonction de la pression d'un gaz présent autour du module reçu dans cette installation ;

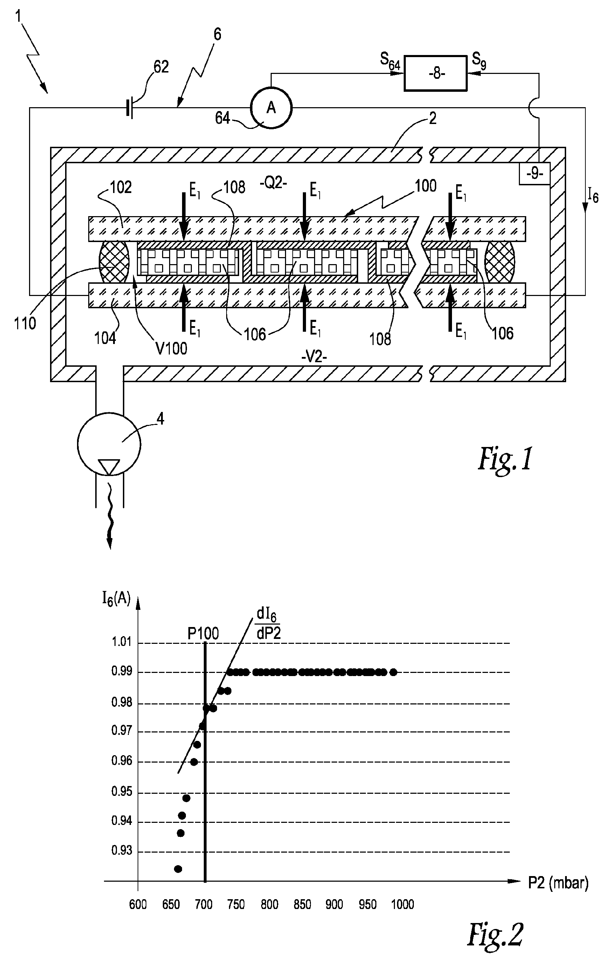

L'installation 1 représentée à la figure 1 est destinée à recevoir un module photovoltaïque 100 qui comprend une plaque avant translucide 102, par exemple en verre, destinée à être tournée vers le soleil en configuration d'utilisation. Le module 100 comprend également une plaque arrière 104 qui peut être en verre ou réalisée dans un autre matériau transparent ou opaque. Le module 100 comprend également plusieurs cellules photovoltaïques 106, réalisées à base de silicium et reliées entre elles par des rubans d'interconnexion 108, eux-mêmes réalisés dans un matériau électriquement conducteur, tel que du cuivre. Ces rubans 108 relient électriquement entre elles les cellules 106, à l'intérieur du volume interne V100 du module 100. Les rubans 108 sont en appui simple contre des bornes non représentées des cellules 106.

Le module 100 comprend également un joint périphérique 110 qui isole le volume V100 de l'extérieur et qui longe les bords des plaques 102 et 104.

La connexion électrique entre les cellules 106 et les rubans 108 est réalisée grâce à un effort d'appui E₁ exercé par les plaques 102 et 104 et qui pousse les rubans 108 contre les bornes des cellules 106. Cet effort E₁ est la résultante de la différence de pression entre l'atmosphère ambiante entourant le module 100 et la pression P100 de l'air ou du gaz présent dans le volume V100. Au cours de l'utilisation du module 100, la pression de l'atmosphère ambiante peut être considérée comme égale ou sensiblement égale à 1000 millibars.

Pour que l'effort d'appui E₁ soit suffisamment intense pour garantir une connexion électrique effective entre les cellules 106 et les rubans 108, il importe que la différence de pression entre l'atmosphère ambiante et le volume V100 soit significative, sans être trop importante.

Cette différence de pression est obtenue par la fabrication, sous vide partiel, du module 100, au sein d'une presse disposée à l'intérieur d'une cloche, comme expliqué ci-dessus.

Lorsque le module 100 a été fabriqué, il peut être contrôlé afin de déterminer la pression effective P100 régnant au sein du volume 100. Cette opération de contrôle est effectuée sur certains modules d'un lot de fabrication, par exemple un module sur cent.

Ce contrôle a lieu en mettant en oeuvre une méthode selon laquelle on introduit le module 100 dans une enceinte 2 qui est fermée dont on note V2 le volume interne. Ce volume V2 contient une quantité Q2 d'azote répartie autour du module 100. L'enceinte 2 est raccordée à une pompe à vide 4 qui est capable de purger progressivement l'enceinte 2, ce qui a pour effet de faire diminuer la pression de la quantité d'azote Q2.

On note P2 la pression de la quantité d'azote Q2 entourant le module 100 au sein du volume V2 de l'enceinte 2.

A titre d'exemple, on considère que la valeur nominale de la pression P100 est de 700 millibars.

Lorsque le module 100 est introduit dans l'enceinte 2, la pression P2 est égale à la pression atmosphérique, ici considérée à 1000 millibars. La mise en service de la pompe 4 permet de faire décroître cette pression P2 progressivement.

L'installation 1 comprend également un circuit de mesure 6 qui est connecté à deux bornes du module 100 normalement utilisées pour le raccorder à un réseau électrique de transport de l'électricité produite par les cellules 106. Ces bornes ne sont pas représentées à la figure 1 pour la clarté du dessin. Ce circuit 6 comprend un générateur de tension 62 raccordé aux deux bornes du module 100, avec interposition d'un ampèremètre 64 qui appartient également au circuit 6. Ainsi, le générateur 62 délivre un courant électrique de tension constante au module 100, l'intensité I₆ de ce courant électrique étant mesurée par l'ampèremètre 64. On considère que le générateur 62 est réglé à l'origine pour délivrer au module 100 un courant d'intensité égale à 1 Ampère lorsque le module fonctionne normalement.

L'installation 1 comprend également une unité électronique 8 à laquelle est fourni le signal de sortie S₆₄ de l'ampèremètre 64.

L'installation 1 comprend également un capteur de pression 9 disposé à l'intérieur du volume V2 de l'enceinte 2 et qui permet de détecter la pression P2. Ce capteur de pression 9 délivre à l'unité 8 un signal électronique S₉ représentatif de la pression P2.

Le circuit 6 permet de détecter une variation de l'impédance du module 100, cette variation d'impédance résultant d'une modification de la répartition des efforts dans ce module, à savoir d'une diminution de l'intensité de l'effort E₁.

En effet, lors du fonctionnement de la pompe 4, la pression P2 diminue progressivement. Lorsque la pression P2 atteint 700 millibars, les pressions P2 et P100 de part et d'autre des plaques 102 et 104 sont égales, de sorte que l'effort d'appui E₁ est nul ou quasi nul et que l'un au moins des rubans d'interconnexion 108 n'est plus comprimé contre la cellule 106 adjacente mais simplement « posé » sur celle-ci, voire légèrement décollé, du fait d'une reprise de forme élastique des plaques avant et arrière 102 et 104 suite à la suppression de leur déformation par le différentiel de pression.

Dans ces conditions, l'impédance Z100 du module 100, telle qu'elle est perçue par le circuit 6, augmente. Comme le générateur 62 délivre une tension constante, l'intensité I₆ est une grandeur représentative de l'impédance E100. Quand l'impédance Z100 augmente, l'intensité I₆ diminue, ce que détecte l'ampèremètre 64 qui adresse à l'unité 8 le signal S₆₄ correspondant.

Ainsi, l'impédance Z100 constitue un paramètre représentatif de l'appui effectif des rubans 108 contre les cellules 106. Par ailleurs, l'intensité I₆ constitue également un paramètre représentatif de cet appui, puisque la tension délivrée par le générateur 62 est constante.

Comme le représente la figure 2, lorsque la pression P2 décroît progressivement de 1000 millibars vers 600 millibars, la valeur de l'intensité I₆ demeure constante jusqu'à environ 750 millibars, valeur à partir de laquelle l'intensité I₆ décroît de façon significative, ce qui est détecté par l'unité 8, sur la base des signaux S₉ et S₆₄.

Un calibrage effectif de l'unité 8 permet de considérer que les pressions P2 et P100 sont sensiblement égales lorsque l'intensité I₆ du courant a diminué de 2% par rapport à sa valeur nominale, à savoir 1 Ampère dans l'exemple. En pratique, le pourcentage N% de l'intensité I₆ fixé pour considérer qu'une variation de cette intensité correspond à l'égalité des pressions P2 et P100 est choisi entre 1 et 5%, la valeur de 2% étant préférentielle. La calibration de l'unité 8 sur le pourcentage de baisse de l'intensité I₆ du courant dépend du type de module utilisé, notamment de la rigidité des plaques avant et arrière qui ne se comportent pas de façon identique lorsque le différentiel de pression devient nul. Le courant diminue plus lentement dans le cas de plaques rigides que dans le cas de plaques souples.

En variante, l'unité 8 peut prendre en compte la pente dI₆/dP2 de la courbe représentative de la valeur de l'intensité I₆ en fonction de la pression P2, c'est-à-dire la rapidité de décroissance de l'intensité I₆. Lorsque la valeur absolue de cette pente dI₆/dP2 dépasse une valeur de seuil prédéterminée, l'unité 8 peut considérer que les pressions P2 et P100 sont égales. Cette pente peut également être calibrée en fonction des caractéristiques mécaniques des plaques 102 et 104.

Lorsque la valeur de la pression P100 a ainsi été déterminée, le fonctionnement de la pompe 4 peut être interrompu et l'enceinte 2 peut être ouverte. La pression P2 augmente alors jusqu'à alors environ 1000 mb et l'effort E₁ retrouve sa valeur normale, ce qui plaque à nouveau les rubans 108 sur les cellules 106. On extrait alors le module 100 qui peut être normalement utilisé puisque le contrôle effectué n'a pas de conséquences sur sa structure ou son fonctionnement.

L'invention tire parti d'un effet de seuil observé lorsque les pressions de part et d'autre des plaques 102 et 104 s'équilibrent. Cet effet de seuil provient essentiellement du fait que les rubans 108 sont en appui simple sur les cellules 106, sans être soudés ou collés à celles-ci, et que cet appui est normalement suffisant pour assurer un contact électrique optimal, sous l'effet de l'effort E₁ résultant de la différence de pression entre la pression P100 et la pression P2 de l'azote autour du module 100. La méthode de contrôle de l'invention revient à annuler temporairement cette différence de pression pour supprimer ou dégrader le contact électrique entre les rubans 108 et les cellules 106, ce qui permet de détecter facilement la pression à laquelle ce phénomène se produit.

On comprend que, compte tenu du caractère très marqué de la décroissance de l'intensité I₆ lorsque les pressions P2 et P100 s'égalisent, l'incertitude sur la détermination de la pression P100 est faible.

La méthode de l'invention peut être mise en oeuvre dans un atelier de fabrication de modules photovoltaïques, de sorte qu'elle permet de réagir sans délai en cas de dérive de la pression des modules en cours de fabrication. En effet, en prélevant certains modules dans un lot de modules en cours de fabrication, il est possible de réagir à une modification des conditions de fonctionnement de la presse, telles que des variations de température ou de pression extérieures qui pourraient avoir une influence négative sur la précision de la réalisation de la dépression au sein des modules en cours de fabrication.

Selon une variante de l'invention, le générateur 62 du circuit 6 peut être un générateur de courant, auquel cas c'est la tension V₆ aux bornes du module 100 qui peut être mesurée grâce à un voltmètre. Une variation de cette tension peut être prise en compte par l'unité 8 pour détecter lorsque la pression P2 devient égale à la pression P100.

Selon une autre variante, on peut utiliser une combinaison des grandeurs tension/intensité d'un courant pour détecter l'atteinte d'une pression P2 égale à la pression du module 100.

L'invention décrite ci-dessus dans le cas où la quantité Q2 est une quantité d'azote. En variante, il peut s'agir d'un autre gaz.

Selon une autre variante de l'invention, la détection de l'égalisation des pressions P2 et P100 peut avoir lieu en mesurant la déformation mécanique de l'une ou l'autre des plaques 102 et 104, voire de ces deux plaques. En effet, ces plaques ont tendance à se cintrer légèrement lorsque la différence de pression entre les pressions P2 et P100 est significative, puis à reprendre une configuration plane lorsque ces pressions s'équilibrent. Cette variation géométrique des plaques 102 et 104 peut être détectée par une méthode optique, par exemple en mesurant le déplacement d'un spot laser réfléchi par une des faces externes du module 100, c'est-à-dire l'une des faces externes d'une des plaques 102 ou 104.

Dans ce cas, l'installation 1 est modifiée pour incorporer une source laser qui dirige un faisceau sur l'une des plaques 102 et 104, ce faisceau étant dévié ou réfléchi par l'une de ces plaques d'une façon qui évolue en fonction des variations de géométrie réelle de cette plaque. Ainsi, un spot du faisceau réfléchi ou dévié se déplace en fonction de la géométrie d'une des plaques 102 et 104 ou de ces deux plaques, ce qui peut être détecté par un observateur ou par une caméra dont le signal de sortie est fourni à l'unité 8.

La valeur de consigne de 700 millibars pour la pression P100 mentionnée ci-dessus peut être modifiée et prendre toute les valeurs entre 0 et 850 mbars.

Les caractéristiques techniques des modes de réalisation et variantes envisagés ci-dessus peuvent être combinées entre elles.

## Revendications

1. Méthode de contrôle de la pression interne d'un module photovoltaïque (100) comprenant une plaque avant (102), une plaque arrière (104), des cellules photovoltaïques (106), des conducteurs (108) d'interconnexion électrique entre les cellules, et un joint périphérique (110), les conducteurs (108) étant en contact par pression avec les cellules (106), sous l'effet d'un effort (E1) résultant d'une dépression régnant à l'intérieur du module, **caractérisée en ce que** cette méthode comprend des étapes consistant à :
a) faire diminuer progressivement la pression (P2) d'une quantité (Q2) de gaz autour du module,
b) détecter, pendant l'étape a), un paramètre physique (Z100) représentatif de l'appui effectif des conducteurs d'interconnexion (108) contre les cellules (106),
c) déterminer une valeur de la pression interne (P100) du module en fonction d'une variation (I₆-N% ; dI₆/dP2) du paramètre physique.

2. Méthode selon la revendication 1, **caractérisée en ce que** l'étape a) est effectuée en disposant le module (100) dans une enceinte (2) à pression contrôlée et en faisant progressivement décroître la pression (P2) à l'intérieur de cette enceinte, à partir de la pression atmosphérique.

3. Méthode selon l'une des revendications précédentes, **caractérisée en ce que** la valeur de la pression (P100) déterminée lors de l'étape c) correspond à la pression pour laquelle le paramètre physique (Z100) varie du fait d'un relâchement de l'effort (E₁) de contact par pression, entre au moins un conducteur d'interconnexion (108) et une cellule photovoltaïque (106).

4. Méthode selon l'une des revendications précédentes, **caractérisée en ce que** le paramètre détecté lors de l'étape b) est une impédance (Z100) du module (100) et **en ce que**, lors de l'étape b), on injecte une puissance électrique dans le module et on détecte une variation d'une composante (I₆, V₆) de cette puissance.

5. Méthode selon la revendication 4, **caractérisée en ce que** le courant injecté à l'étape b) est à tension constante et la composante détectée est l'intensité (I₆) du courant.

6. Méthode selon la revendication 4, **caractérisée en ce que** le courant injecté à l'étape b) est à intensité constant et la composante détectée est la tension (V6) aux bornes du module.

7. Méthode selon l'une des revendications 1 à 3, **caractérisée en ce que** le paramètre détecté lors de l'étape b) est un paramètre géométrique de la plaque avant (102) et/ou de la plaque arrière (104) du module (100).

8. Méthode selon la revendication 7, **caractérisée en ce que** le paramètre détecté lors de l'étape b) est représentatif de la planéité de la plaque avant (102) ou de la plaque arrière (104).

9. Méthode selon l'une des revendications 7 ou 8, **caractérisée en ce que** lors de l'étape b), le paramètre est détecté par voie optique, notamment par déplacement d'au moins un faisceau lumineux réfléchi ou dévié par la plaque avant (102) ou la plaque arrière (104).

10. Méthode selon l'une des revendications précédentes, **caractérisée en ce que** lors de l'étape c), la pression interne (P100) du module est considérée comme égale à la pression de la quantité (Q2) de gaz autour du module (100) lorsque la valeur du paramètre physique (I₆) détecté varie d'un pourcentage prédéterminé par rapport à sa valeur d'origine, ce pourcentage étant compris entre 1 et 5%, de préférence égal à 2%.

11. Installation de contrôle de la pression interne d'un module photovoltaïque (100), ce module comprenant une plaque avant (102), une plaque arrière (104), des cellules photovoltaïques (106), des conducteurs (108) d'interconnexion électrique entre les cellules, et un joint périphérique (110), les conducteurs étant en contact par pression avec les cellules, sous l'effet d'un effort (E₁) résultant d'une dépression régnant à l'intérieur du module, **caractérisée en ce que** cette installation comprend :
- une enceinte (2) de réception du module (100) au sein d'une quantité (Q2) de gaz, cette enceinte étant équipée de moyens (4) pour faire diminuer la pression (P2) de cette quantité de gaz,
- des moyens (64) de détection d'un paramètre physique (Z100) représentatif de l'appui effectif des conducteurs d'interconnexion (108) sur les cellules (106) et
- des moyens (8) de détermination de la pression interne (P100) du module, sur la base d'un signal de sortie (S₆₄) des moyens de détection (64).

## Patentansprüche

1. Verfahren zur Steuerung des Innendrucks eines Photovoltaikmoduls (100), das eine Vorderplatte (102), eine Rückplatte (104), Photovoltaikzellen (106), Leitungen (108) für die elektrische Verbindung zwischen den Zellen und eine Umfangsdichtung (110) aufweist, wobei die Leitungen (108) unter der Wirkung einer Kraft (E1), die aus einem im Inneren des Moduls herrschenden Unterdruck resultiert, in Druckkontakt mit den Zellen (106) sind, **dadurch gekennzeichnet, dass** das Verfahren Schritte umfasst, die darin bestehen:
a) allmählich den Druck (P2) einer Gasmenge (Q2) um das Modul herum zu verringern,
b) während des Schrittes a) einen physikalischen Parameter (Z100), der repräsentativ für die effektive Auflage der Verbindungsleitungen (108) gegen die Zellen (106)ist, zu detektieren,
c) einen Wert des Innendrucks (P100) des Moduls, abhängig von einer Änderung (I₆-N%; dI₆/dP2) des physikalischen Parameters zu bestimmen.

2. Verfahren nach Anspruch 1, **dadurch gekennzeichnet, dass** der Schritt a) durchgeführt wird, indem das Modul (100) in eine Umhüllung (2) mit gesteuertem Druck angeordnet wird und progressiv der Druck (P2) im Inneren dieser Umhüllung vom atmosphärischen Druck ab abgesenkt wird.

3. Verfahren nach einem der vorhergehenden Ansprüche, **dadurch gekennzeichnet, dass** der bei dem Schritt c) bestimmte Druckwert (P100) dem Druck entspricht, bei dem der physikalische Parameter (Z100) sich aufgrund der Tatsache eines Nachgebens der Kraft (E₁) des Druckkontaktes zwischen mindestens einer Verbindungsleitung (108) und einer photovoltaischen Zelle (106) ändert.

4. Verfahren nach einem der vorhergehenden Ansprüche, **dadurch gekennzeichnet, dass** der bei dem Schritt b) detektierte Parameter eine Impedanz (Z100) des Moduls (100) ist, und dass bei dem Schritt b) eine elektrische Leistung in das Modul injiziert wird und eine Änderung einer Komponente (I₆, V₆) dieser Leistung detektiert wird.

5. Verfahren nach Anspruch 4, **dadurch gekennzeichnet, dass** der bei Schritt b) injizierte Strom bei konstanter Spannung vorgesehen ist und die detektierte Komponente die Stromstärke (I₆) ist.

6. Verfahren nach Anspruch 4, **dadurch gekennzeichnet, dass** der in Schritt b) injizierte Strom mit konstanter Stärke vorgesehen ist und die detektierte Komponente die Spannung (V6) an den Anschlüssen des Moduls ist.

7. Verfahren nach einem der Ansprüche 1 bis 3, **dadurch gekennzeichnet, dass** der bei Schritt b) detektierte Parameter ein geometrischer Parameter der Vorderplatte (102) und/oder der Rückplatte (104) des Moduls (100) ist.

8. Verfahren nach Anspruch 7, **dadurch gekennzeichnet, dass** der bei Schritt b) detektierte Parameter repräsentativ für die Ebenheit der Vorderplatte (102) oder der Rückplatte (104) ist.

9. Verfahren nach einem der Ansprüche 7 oder 8, **dadurch gekennzeichnet, dass** bei dem Schritt b) der Parameter auf optischem Wege, insbesondere durch Verschiebung mindestens eines von der Vorderplatte (102) oder der Rückplatte (104) reflektierten oder abgelenkten Lichtbündels detektiert wird.

10. Verfahren nach einem der vorhergehenden Ansprüche, **dadurch gekennzeichnet, dass** bei dem Schritt c) der Innendruck (P100) des Moduls als gleich dem Druck der Gasmenge (Q2) um das Modul (100) herum angesehen wird, wenn der Wert des detektierten physikalischen Parameters (I₆) um einen vorbestimmten Prozentsatz in Bezug auf seinen Ursprungswert variiert, wobei dieser Prozentsatz zwischen 1 und 5% liegt, vorzugsweise gleich 2% ist.

11. Vorrichtung zur Steuerung des Innendrucks eines photovoltaischen Moduls (100), wobei dieses Modul eine Vorderplatte (102), eine Rückplatte (104), photovoltaische Zellen (106), Leitungen (108) zur elektrischen Verbindung zwischen den Zellen und eine Umfangsdichtung (110) umfasst, wobei die Leitungen unter der Wirkung einer Kraft (E₁), die aus einem im Inneren des Moduls herrschenden Unterdruck resultiert, in Druckkontakt mit den Zellen sind, **dadurch gekennzeichnet, dass** diese Vorrichtung umfasst:
- eine Umhüllung (2) zur Aufnahme des Moduls (100) in einer Gasmenge (Q2), wobei diese Umhüllung mit Mitteln (4) zum Verringern des Drucks (P2) dieser Gasmenge ausgerüstet ist,
- Mittel (64) zur Detektion eines physikalischen Parameters (Z100), der für die effektive Auflage der Verbindungsleitungen (108) gegen die Zellen (106) repräsentativ ist, und
- Mittel (8) zur Bestimmung des Innendrucks (P100) des Moduls auf der Grundlage eines Ausgangssignals (S₆₄) der Detektionsmittel (64).

## Claims

1. A control method for checking and controlling the internal pressure of a photovoltaic module (100) comprising a front plate (102), a rear plate (104), photovoltaic cells (106), conductors (108) for electrical interconnection between the cells, and a peripheral seal (110), with the conductors (108) being in pressure contact with the cells (106), under the effect of a force (E1) resulting from a negative pressure prevailing within the interior of the module, **characterised in that** the said method includes the following steps consisting of:
a) gradually causing the progressive reducing of the pressure (P2) of a quantity (Q2) of gas around the module;
b) detecting, during the step a), a physical parameter (Z100) representative of the actual pressing of the interconnection conductors (108) against the cells (106);
c) determining a value of the internal pressure (P100) of the module as a function of a variation (I₆-N%; dIₑ/dP2) in the physical parameter.

2. A method according to claim 1, **characterised in that** the step a) is carried out by placing the module (100) in a controlled pressure enclosure (2) and by gradually causing the progressive reducing of the pressure (P2) within the interior of this enclosure, from the atmospheric pressure.

3. A method according to one of the preceding claims, **characterised in that** the value of the pressure (P100) determined during the step c) corresponds to the pressure for which the physical parameter (Z100) varies due to the easing of the pressure contact force (E₁), between at least one interconnection conductor (108) and one photovoltaic cell (106).

4. A method according to one of the preceding claims, **characterised in that** the parameter detected during the step b) is an impedance (Z100) of the module (100) and **in that**, during the step b), an electricity current is injected into the module and a variation in a component (I₆, V₆) of this current is detected.

5. A method according to claim 4, **characterised in that** the current injected during the step b) is at a constant voltage and the component detected is the intensity (I₆) of the current.

6. A method according to claim 4, **characterised in that** the current injected during the step b) is at a constant intensity and the component detected is the voltage (V6) at the terminals of the module.

7. A method according to one of claims 1 to 3, **characterised in that** the parameter detected during the step b) is a geometric parameter of the front plate (102) and/or the rear plate (104) of the module (100).

8. A method according to claim 7, **characterised in that** the parameter detected during the step b) is representative of the planarity of the front plate (102) or the rear plate (104).

9. A method according to any one of claims 7 or 8, **characterised in that** during the step b), the parameter is detected by optical means, in particular by displacement of at least one light beam that is reflected or deflected by the front plate (102) or the rear plate (104).

10. A method according to one of the preceding claims, **characterised in that** during the step c), the internal pressure (P100) of the module is considered to be equal to the pressure of the quantity (Q2) of gas around the module (100) when the value of the physical parameter (I₆) detected varies by a predetermined percentage relative to its original value, this percentage being comprised between 1% and 5%, preferably equal to 2%.

11. A control facility for checking and controlling the internal pressure of a photovoltaic module (100), this module comprising a front plate (102); a rear plate (104), photovoltaic cells (106), the electrical interconnection conductors (108) for interconnection between the cells, and a peripheral seal (110), with the conductors being in pressure contact with the cells, under the effect of a force (E₁) resulting from a negative pressure prevailing within the interior of the module, **characterised in that** this control facility includes:
- a module receiving enclosure (2), for receiving the module (100) within a quantity (Q2) of gas, the said enclosure being provided with the means (4) for causing the reducing of the pressure (P2) of this quantity of gas;
- parameter detection means (64), for detecting a physical parameter (Z100) representative of the actual pressing of the interconnection conductors (108) on the cells (106); and
- pressure determination means (8), for determining the internal pressure (P100) of the module, on the basis of an output signal (S₆₄) from the detection means (64).
